(19) Europäisches Patentamt
European Patent Office
Office européen des brevets

(11) **EP 3 065 415 B1**

(12) **FASCICULE DE BREVET EUROPEEN**

(45) Date de publication et mention de la délivrance du brevet:
**12.12.2018 Bulletin 2018/50**

(51) Int Cl.:
*H04R 1/00* *(2006.01)*          *H04R 1/24* *(2006.01)*
*B81C 1/00* *(2006.01)*          *H04R 31/00* *(2006.01)*
*H04R 17/00* *(2006.01)*

(21) Numéro de dépôt: **16158129.3**

(22) Date de dépôt: **01.03.2016**

(54) **DISPOSITIF A MEMBRANES ACTIONNABLES ET HAUT-PARLEUR DIGITAL COMPORTANT AU MOINS UN TEL DISPOSITIF**

VORRICHTUNG MIT BETÄTIGBAREN MEMBRANEN, UND DIGITALER LAUTSPRECHER, DER MINDESTENS EINE SOLCHE VORRICHTUNG UMFASST

DEVICE WITH OPERABLE DIAPHRAGMS AND DIGITAL LOUDSPEAKER COMPRISING AT LEAST ONE SUCH DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.03.2015 FR 1551745**

(43) Date de publication de la demande:
**07.09.2016 Bulletin 2016/36**

(73) Titulaire: **Commissariat à l'Énergie Atomique et aux Énergies Alternatives 75015 Paris (FR)**

(72) Inventeur: **CASSET, Fabrice 38570 Tencin (FR)**

(74) Mandataire: **Brevalex 95, rue d'Amsterdam 75378 Paris Cedex 8 (FR)**

(56) Documents cités:
**EP-A1- 2 747 452        WO-A2-2004/019652**
**JP-A- 2013 102 024**

• **Rémy Dejaeger: "Modélisations multiphysiques, réalisation et expérimentations d'un haut-parleur digital matriciel piézoélectrique MEMS", , 1 janvier 2014 (2014-01-01), XP055228299, Université de Lyon Extrait de l'Internet: URL:http://theses.insa-lyon.fr/publication /2014ISAL0054/these.pdf [extrait le 2015-11-13]**
• **NEUMANN J J ET AL: "CMOS-MEMS membrane for audio-frequency acoustic actuation", SENSORS AND ACTUATORS A, ELSEVIER SEQUOIA S.A., LAUSANNE, CH, vol. 95, no. 2-3, 1 janvier 2002 (2002-01-01), pages 175-182, XP004377889, ISSN: 0924-4247, DOI: 10.1016/S0924-4247(01)00728-2**

**Description**

**DOMAINE TECHNIQUE ET ÉTAT DE LA TECHNIQUE ANTÉRIEURE**

La présente invention se rapporte à un dispositif à membranes actionnables et à un haut-parleur digital comportant au moins un tel dispositif.

Un haut-parleur digital comporte des membranes actionnables déplaçant de l'air afin d'émettre des sons.

Le développement d'appareils nomades proposant toujours plus de fonctionnalités, des composants toujours plus performants et de plus en plus intégrés sont développés. Les composants MEMS, de par leur mode de fabrication collective, et la potentialité de co-intégration de différents composants sur une même puce ouvrent de nouvelles perspectives pour les industriels.

Les haut-parleurs sont des composants présents dans un grand nombre d'applications téléphone portable, écran plat... et leur miniaturisation ainsi que leur intégration deviennent de première importance.

Les technologies MEMS sont particulièrement bien adaptées à la réalisation de haut-parleurs digitaux, dans lesquels le son est reconstruit à partir des contributions élémentaires d'un grand nombre de membranes élémentaires, et plus généralement des transducteurs acoustiques ultrafins ou speaklets. Chaque transducteur peut être actionné indépendamment et le son à émettre est reconstruit en se basant sur le principe de l'additivité des sons élémentaires des transducteurs dans l'air.

Un exemple de haut-parleur digital est décrit dans le document Dejaeger et al. "Development and characterization of a piezoelectrically actuated MEMS digital loudspeaker" Proc. Eurosensors XXVI, September 9-12, 2012. Dans ce document, les speaklets sont à actionnement piézoélectrique, ce qui permet de donner un mouvement aux speaklets dans les deux directions, et donc de contrôler précisément le pulse acoustique qu'ils génèrent.

Néanmoins, il a été constaté que les membranes MEMS élémentaires, génèrent d'autant moins de basses fréquences que la fréquence de résonance de la membrane est haute. En effet, si on trace la variation de la pression surfacique en fonction la fréquence, on observe que, avant le pic de résonance, la pression augmente. Cette augmentation, de l'ordre de 12dB par octave, est liée au comportement mécanique de la membrane, qui est dominé par la raideur. Ce comportement mécanique s'approche d'un système masse-ressort à un degré de liberté. Au-delà du pic de résonance, la pression reste constante, car le comportement de la membrane est dominé par la masse.

Par ailleurs, la fréquence de résonance d'une membrane est d'autant plus haute que la membrane est petite à épaisseur constante. Afin de générer des basses fréquences, il est donc préférable de mettre en oeuvre des membranes de grande taille.

Cependant, lorsque la matrice de speaklets est trop grande, par exemple lorsque son diamètre est supérieur à 2500μm, des distorsions peuvent apparaître du fait des différences de marche, i.e. la différence de trajet de l'onde acoustique entre deux émetteurs.

Par ailleurs, les membranes sont également soumises à des contraintes résiduelles. Dans le cas des speaklets, la fréquence de résonance générée est d'autant plus haute qu'il y a des contraintes résiduelles. Par conséquent la présence de ces contraintes résiduelles gêne la génération de basses fréquences.

En outre, l'existence de ces contraintes résiduelles à la fois dans les haut-parleurs digitaux et dans d'autres dispositifs mettant en oeuvre des membranes actionnables, rend le comportement de membranes peu prévisible et leur commande présente une faible précision. En effet, du fait de la présence de ces contraintes résiduelles, le système de membranes n'a pas le comportement prévu d'un système de membranes planes.

Au vu de ce qui précède, dans le cas d'un dispositif comportant un grand nombre de membranes ou des membranes de différentes tailles, ces membranes vont donc présenter des états de contrainte pouvant en particulier varier en fonction de leur position géographique sur le substrat, il n'est pas envisageable d'utiliser un procédé de fabrication permettant de pallier ces inconvénients pour toutes les membranes.

Le document EP 2 747 452 décrit un dispositif à membrane, pouvant former un haut-parleur, comportant des premiers et deuxièmes actionneurs pour contrôler le déplacement dynamique de la membrane.

Le document JP 2013102024 décrit un élément piézoélectrique pouvant être utilisé comme capteur, dans lequel le contrôle des contraintes dans le matériau piézoélectrique peut se faire en maîtrisant le rapport entre les différentes orientations cristallines.

Le document R. DEJAEGER : « Modelisations multiphysiques, réalisation et expérimentation d'un haut-parleur digital matriciel piezoélectriques MEMS », Université de Lyon, pages 25-27; 49-59; 192, 01/01/2014 décrit un haut-parleur et l'effet des contraintes résiduelles sur la reproduction des basses fréquences

**•EXPOSÉ DE L'INVENTION**

C'est par conséquent un but de la présente invention d'offrir un dispositif à membranes actionnables offrant une précision de commande augmentée.

Le but de la présente invention est atteint par un dispositif comportant une plaque, au moins un premier actionneur apte à imposer une déformation hors-plan de la plaque, au moins deux membranes suspendues à la plaque, des deuxièmes actionneurs pour chacune des membranes, chacun des deuxièmes actionneurs étant apte à imposer une déformation hors-plan à une membrane, chaque premier et deuxième actionneur étant commandables individuellement et des moyens de commande des premier et deuxième actionneurs aptes à appliquer une contrainte aux membranes par l'intermédiaire de la plaque afin de réduire des contraintes résiduelles internes à chaque membrane et avantageusement les supprimer.

En d'autres termes, on cherche à supprimer ces contraintes résiduelles internes aux membranes en leur appliquant une contrainte s'opposant aux contraintes résiduelles afin d'atteindre un système de membranes planes dont on maîtrise le comportement. Pour cela, on déforme le support auquel sont suspendues les membranes. Lorsque les contraintes résiduelles sont une compression, la contrainte extérieure appliquée est une traction et inversement, lorsque les contraintes résiduelles sont une traction, la contrainte extérieure appliquée est une compression.

Le type de contrainte appliqué par la déformation de la plaque est obtenu en déformant la plaque dans un sens ou dans l'autre.

Les membranes sont avantageusement réalisées en dehors du plan moyen de la plaque, de préférence au niveau d'une face de celle-ci.

On déforme la plaque qui va appliquer une contrainte sur les membranes, la contrainte appliquée aux membranes étant choisie pour réduire et de préférence annuler les contraintes résiduelles existant dans les membranes.

Dans le cas d'un haut-parleur digital, les contraintes résiduelles étant annulées dans les membranes, celles-ci présente une meilleure aptitude à émettre dans les basses fréquences.

Avantageusement, par exemple dans le cas d'un haut-parleur digital, la plaque peut être mise en vibration de sorte qu'elle génère une basse fréquence inférieure à celle produite par les deuxièmes membranes. Très avantageusement, la plaque est mise en vibration alors qu'elle est déjà déformée pour réduire, voire supprimer les contraintes résiduelles internes aux membranes.

La présente invention a alors pour objet un dispositif à membranes actionnables comportant une plaque, une pluralité de membranes suspendues à ladite plaque, ladite pluralité de membranes étant le siège de contraintes mécaniques résiduelles, au moins un premier actionneur apte à déformer la plaque hors de son plan, des deuxièmes actionneurs, chaque deuxième actionneur étant apte à déformer une membrane hors de son plan, et une électronique de pilotage apte à générer des deuxièmes signaux de commande aux deuxièmes actionneurs afin de mettre les membranes en vibration et apte à générer des premiers signaux de commande au premier actionneur de sorte qu'il provoque une déformation de la plaque afin qu'elle se trouve dans un état déformé, qui est tel que des contraintes mécaniques induites, s'appliquent aux membranes et au moins réduisent les contraintes résiduelles des membranes.

On entend par contraintes résiduelles des membranes, des contraintes pouvant être induites par l'empilement technologiques des membranes et/ou par l'environnement technologique de ces membranes, par exemple le boîtier d'encapsulation du dispositif, l'environnement atmosphérique du dispositif et notamment la température et la pression... Selon l'invention la déformation de la plaque, induite par le premier actionneur permet ainsi de compenser tout ou partie des contraintes résiduelles des membranes indépendamment de leur actionnement par les seconds actionneurs. Les contraintes mécaniques induites peuvent être réparties sur la plaque de façon uniforme ou non, par exemple suivant le résultat recherché en jouant notamment sur la forme de la plaque et sur la position du ou des premiers actionneurs.

Avantageusement, les contraintes mécaniques induites appliquées aux membranes annulent les contraintes résiduelles des membranes.

De préférence, l'électronique de pilotage est apte en outre à générer des signaux de commande additionnels au premier actionneur de sorte qu'il provoque une mise en vibration de la plaque, indépendamment de sa mise dans son état déformé

Les premiers signaux de commande provoquant la déformation de la plaque sont des signaux continus. Les signaux de commande additionnels provoquant la mise en vibration de la plaque peuvent être des signaux alternatifs.

Le premier actionneur et/ou les deuxièmes actionneurs sont par exemple des actionneurs piézoélectriques et/ou ferroélectriques.

La surface totale du ou des premiers actionneurs est avantageusement comprise entre 5% et 40% de la surface de la plaque et préférentiellement égale à 25% de la surface de la plaque et/ou dans lequel la surface totale des deuxièmes actionneurs est avantageusement comprise entre 5% et 40% de la surface totale des membranes et préférentiellement égale à 25% de la surface totale des membranes.

Par exemple, le dispositif peut comporter un ou plusieurs premiers actionneurs répartis le long d'au moins un bord de la plaque.

Dans un exemple de réalisation, la plaque a la forme d'un disque et le ou les premiers actionneurs ont la forme d'arc de cercle centré sur le centre du disque. Le premier actionneur peut avoir la forme d'un anneau centré sur le centre du disque.

Dans un autre exemple de réalisation, la plaque a la forme d'un rectangle et dans lequel le dispositif comporte plusieurs premiers actionneurs s'étendant parallèlement à au moins deux bords opposés de la plaque.

De préférence, les membranes sont situées sur une face de la plaque.

La présente invention a également pour objet un haut-parleur digital comportant au moins un dispositif à membranes actionnables selon l'invention.

La présente invention a également pour objet une micropompe hydraulique comportant au moins un dispositif à membranes actionnables selon l'invention.

La présente invention a également pour objet un dispositif d'émission ultrasonore comportant au moins un dispositif à membranes actionnables selon l'invention.

La présente invention a également pour objet un procédé de fabrication d'un dispositif à membranes actionnables selon l'invention, comportant les étapes :

a) choix d'un nombre de membranes et des dimensions respectives de celles-ci,
b) détermination des contraintes résiduelles aux membranes,
c) détermination des dimensions de la plaque,
d) détermination de la déformation requise de la plaque pour réduire et avantageusement annuler les contraintes résiduelles dans les membranes,
e) fabrication d'un dispositif à membranes actionnables comportant une plaque présentant les dimensions déterminées, au moins un premier actionneur apte à provoquer la déformation déterminée de la plaque, des membranes ayant les dimensions choisies et des deuxièmes actionneurs aptes à mettre en vibration les membranes.

Les étapes b), c) et d) sont avantageusement réalisées par une méthode d'éléments finis.

Lors de l'étape e) le premier actionneur et les deuxièmes actionneurs peuvent être réalisés simultanément.

L'étape e) met de préférence en oeuvre des procédés de fabrication microélectroniques.

La présente invention a également pour objet un procédé de commande d'un haut-parleur digital selon l'invention comportant les étapes :

- génération d'un premier signal continu de commande au premier actionneur provoquant la déformation de la plaque,
- génération de deuxièmes signaux de commande à tout ou partie des membranes en fonction du son à produire.

Le procédé de commande d'un haut-parleur digital peut avantageusement comporter l'étape supplémentaire de génération d'un signal de commande additionnel de type alternatif au premier actionneur mettant en vibration la plaque. Le signal additionnel alternatif peut être généré alors que le premier signal de commande continu est déjà généré.

**BRÈVE DESCRIPTION DES DESSINS**

La présente invention sera mieux comprise sur la base de la description qui va suivre et des dessins en annexe sur lesquels:

- la figure 1 est une vue en perspective schématique d'un exemple de dispositif selon l'invention en forme de disque,
- la figure 2 est une vue en coupe transversale d'une variante du dispositif de la figure 1 comportant moins de membranes,

- la figure 3A est une vue en coupe transversale du dispositif de la figure 2 dans un premier état d'actionnement,
- la figure 3B est une vue en coupe transversale du dispositif de la figure 2 dans un deuxième état d'actionnement,
- la figure 4 est une vue en perspective schématique d'une variante du dispositif de la figure 1,
- la figure 5 est une vue en perspective schématique d'un exemple de dispositif de forme rectangulaire,
- la figure 6 est une représentation graphique de la variation de la fréquence d'un haut parleur digital en fonction de l'épaisseur du substrat,
- les figures 7A à 7R sont des représentations schématiques d'étapes d'un exemple de procédé de réalisation d'un dispositif selon l'invention.

**EXPOSÉ DÉTAILLÉ DE MODES DE RÉALISATION PARTICULIERS**

Dans la description qui va suivre, l'invention va être principalement décrite dans une application aux haut-parleurs digitaux, mais la présente invention s'applique à d'autres domaines tels que, par exemple celui des micropompes hydrauliques et celui des dispositifs d'émission ultrasonore.

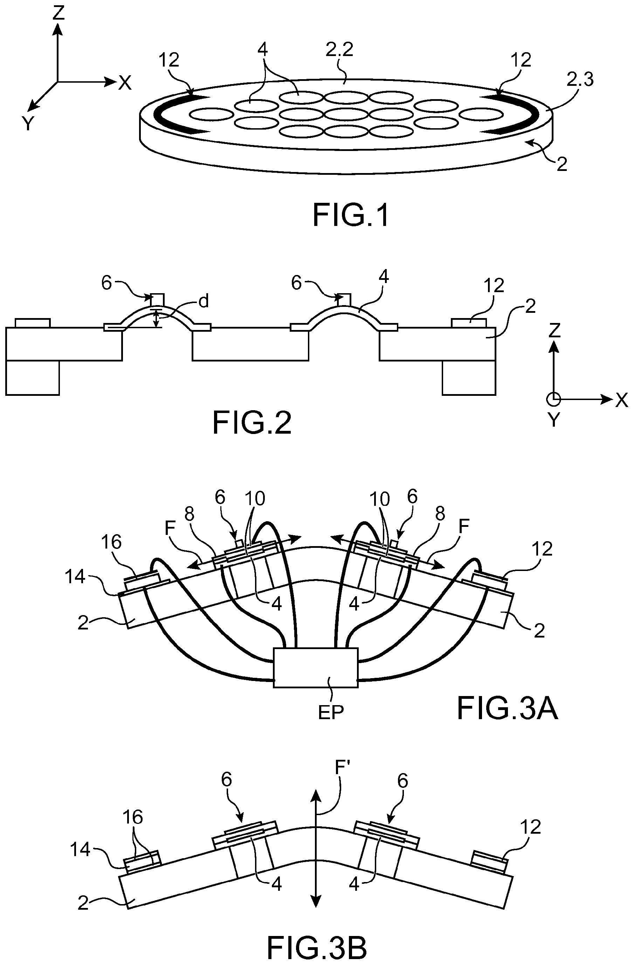

Sur la figure 1, on peut voir un exemple d'un dispositif à membranes actionnables représenté schématiquement pouvant être mis en oeuvre dans un haut-parleur digital selon un exemple de réalisation.

Le dispositif D1 comporte un premier élément 2 en forme de plaque et des deuxièmes éléments formant des membranes 4, lesdites membranes 4 étant suspendues sur la plaque 2 comme on peut le voir sur la figure 2. Dans l'exemple représenté, la plaque 2 est en forme de disque ainsi que les membranes 4.

De préférence, le dispositif est réalisé par des techniques microélectroniques, le premier élément 2 étant un substrat qui est structuré.

Dans l'exemple représenté, les membranes 4 sont réalisées sur une face de la plaque 4, par exemple par dépôt de couches et structuration du substrat et des couches.

Sur la figure 2, les membranes sont représentées déformées afin de symboliser la déformation due aux contraintes résiduelles. Cette déformation n'est pas à l'échelle.

Le dispositif comporte pour chaque membrane 4 au moins un actionneur 6 apte à appliquer une déformation hors-plan à la membrane 4.

De préférence, les actionneurs sont des actionneurs piézoélectriques et/ou ferroélectriques qui peuvent permettre une déformation hors plan dans les deux sens, i.e. vers le haut et vers le bas dans la représentation de la figure 2, ce qui permet de contrôler précisément les impulsions acoustiques qu'elles génèrent

En variante et de manière non limitative, des actionneurs électrostatiques, magnétiques, thermiques... pourraient être mis en oeuvre.

Comme cela est schématisé sur les figures 3A et 3B, les actionneurs piézoélectriques comportent un matériau piézoélectrique 8 et des électrodes 10 de part et d'autre du matériau piézoélectrique 8 pour lui appliquer un champ électrique et provoquer sa déformation.

Lorsqu'un champ électrique est appliqué au matériau piézoélectrique, celui-ci se déforme alors que la membrane n'est pas déformée, il apparaît alors un effet bilame qui a pour effet de courber l'ensemble membrane - matériau piézoélectrique. Le sens de la courbure varie selon le sens du champ électrique appliqué au matériau.

Sur les figures 2, 3A et 3B, les actionneurs 6 sont disposés au centre des membranes 4 sur leur face opposée à la plaque 2.

Le dispositif comporte également au moins un actionneur 12 pour appliquer une déformation hors-plan à la plaque 2.

De préférence, également l'actionneur 12 est un actionneur piézoélectrique et/ou ferroélectrique mais il pourrait s'agir en variante d'un actionneur électrostatique, magnétique, thermique.

Dans l'exemple représenté sur la figure 1 , le dispositif comporte deux actionneurs en forme de tronçons d'arc de cercle disposés l'un par rapport à l'autre de manière diamétralement opposée et disposés au niveau du bord 2.3 sur la face supérieure 2.1 de la plaque.2 de sorte à appliquer un effort uniformément réparti à la plaque. Les actionneurs 12 sont disposés de sorte à ne pas agir sur les membranes 4.

La plaque 2 est destinée à être maintenue par ses bords latéraux pour pouvoir au moins être déformée. Le maintien de la plaque 2 est schématisé sur la figure 2.

Comme pour les actionneurs 6, les actionneurs 12 comportent un matériau piézoélectrique ou ferroélectrique 14 et des électrodes 16 de part et d'autre du matériau piézoélectrique ou ferroélectrique 14 pour lui appliquer une polarisation et provoquer sa déformation.

De préférence, les actionneurs du substrat seront réalisés en même temps que les actionneurs des membranes.

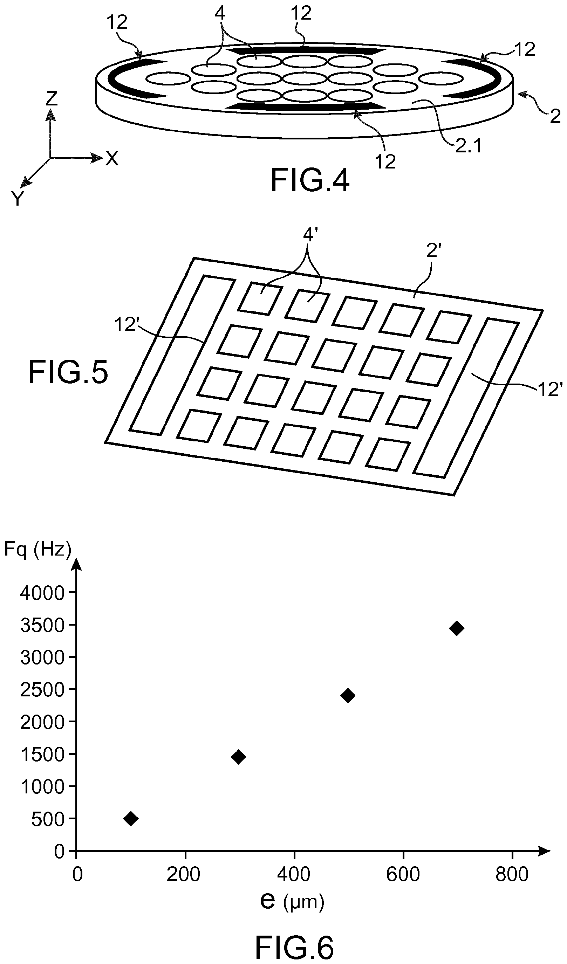

Sur la figure 4, on peut voir une variante de réalisation du dispositif de la figure 1 comportant quatre actionneurs 12 également en forme de tronçons d'arc de cercle réparties uniformément sur le bord périphérique de la plaque sur sa face supérieure 2.1 de la plaque, de sorte à appliquer un effort uniformément réparti à la plaque.

En variante encore, un seul actionneur 12 en forme d'anneau pourrait être mis en oeuvre, celui-ci bordant le bord extérieur la plaque.

Les électrodes des actionneurs 6 et 12 sont reliées électriquement de manière séparée à une source de polarisation V, la polarisation de chaque paire d'électrodes étant commandée individuellement par une électronique de pilotage EP.

De préférence, la surface des actionneurs 12, 6 est comprise entre 5% et 40% de la surface de la plaque 2 et des membranes 4 respectivement, préférentiellement égale 25% de sorte à obtenir un actionnement suffisant avec un encombrement limité des actionneurs.

Les dimensions de la plaque sont choisies de sorte à permettre sa déformation hors plan par le ou les actionneurs, notamment l'épaisseur de la plaque 2 est choisie pour permettre cette déformation tout en étant apte à offrir une rigidité mécanique suffisant pour ne pas flamber.

De préférence, la déformée maximale de la plaque engendrée par les actionneurs 12 est telle qu'elle reste faible par rapport aux dimensions de la plaque, par exemple, la flèche de la déformée maximale est de l'ordre de quelques dizaines de $\mu$m. La déformation de la plaque est telle qu'elle n'endommage pas la plaque et ne parasite pas le fonctionnement des membranes.

Par exemple la plaque est en un matériau semiconducteur, par exemple en silicium, les membranes sont par exemple en silicium polycristallin, en silicium monocristallin, en oxyde, les électrodes sont par exemple en platine, en ruthénium, ... et le matériau piézoélectrique ou ferroélectrique est par exemple en PZT, AlN, ZnO ou BST...

Le fonctionnement de ce dispositif va maintenant être décrit.

Le haut-parleur digital est piloté par une électronique de pilotage EP qui transcrit le son à émettre en commandes électriques des membranes individuelles ainsi que de la plaque.

Un champ électrique est préalablement appliqué à l'actionneur 12 ou aux actionneurs 12 de la plaque 2 afin de provoquer sa déformation hors du plan et à appliquer une contrainte aux membranes 4. Le champ électrique est généré par application d'une tension continue entre les électrodes des actionneurs 12. Ainsi la plaque 4 est déformée en permanence au moins pendant le fonctionnement du haut-parleur.

Le type de contrainte appliquée aux membranes dépend du sens de déformation de la plaque 2 et donc du sens du champ électrique.

Dans le cas des exemples représentés où les membranes sont formées sur la face supérieure de la plaque, si la plaque est déformée vers le bas, une compression est appliquée aux membranes 4, ce qui permet de compenser les contraintes résiduelles en tension existant dans les membranes 4. Si la plaque 2 est déformée vers le haut, une tension est appliquée aux membranes ce qui permet de compenser les contraintes résiduelles en compression existant dans les membranes. Inversement, si les membranes étaient sur la face inférieure de la plaque, une compression serait appliquée en déformant la plaque vers le haut et une tension serait appliquée en déformant la plaque vers le bas.

L'amplitude de la déformation de la plaque dépend de la valeur du champ électrique appliqué à l'actionneur ou aux actionneurs 12.

Les membranes 4 sont ensuite mises en vibration en fonction du son à reproduire en polarisant tout ou partie des actionneurs des membranes 4 au moyen d'une tension alternative ou au moyen d'une tension comprenant une composante alternative et une composante continue dans le cas de matériaux ferroélectriques tels que le PZT.

Du fait de la précontrainte de compensation appliquée à toutes les membranes 4 par la déformation de la plaque 2 qui réduit et avantageusement supprime les contraintes résiduelles dans les membranes, le système de membranes a un comportant proche, voire le comportement, d'un système à membranes planes qui est maîtrisé.

Dans le cas d'un haut-parleur digital, le fait d'avoir annulé ces contraintes internes permet aux membranes 4 de fonctionner à plus basse fréquence que lorsque les contraintes internes ne sont pas compensées. Grâce à la compensation des contraintes internes, les fréquences peuvent être rabaissées de plusieurs dizaines de pourcents.

Sur la figure 3A, on peut voir la plaque 2 déformée vers le haut sous l'action des actionneurs 12. La mise en vibration hors-plan des membranes 4 résulte de l'effet bilame suite à la déformation dans le plan des actionneurs symbolisée par les flèches F.

La plaque peut être déformée pour réduire seulement les contraintes résiduelles et non les annuler. Ceci peut être intéressant dans le cas où des plaques peuvent à partir d'un seuil de contrainte, devenir bistable. La compensation en partie des contraintes pourra par exemple empêcher ce phénomène.

De manière très avantageuse, est superposée à la tension continue de déformation permanente une tension alternative qui s'applique également entre les électrodes des actionneurs 12 pour mettre en vibration la plaque 2 de sorte qu'elle génère une basse fréquence, formant elle-même une membrane du haut-parleur digital, le son produit par la plaque 2 s'additionnant aux sons produits par les membranes 4. La plaque est dimensionnée pour pouvoir générer des basses fréquences.

Du fait de la grande surface de la plaque 2 par rapport aux membranes 4, elle est apte à générer des basses fréquences plus basses que celles générées par les petites membranes, elle est donc complémentaire dans la reproduction du son. La plaque pourra générer par exemple des fréquences de quelques centaines de Hz à quelques kHz alors que les membranes généreront des fréquences allant de quelques kHz à plusieurs dizaines de kHz, voire centaines de kHz.

La tension alternative est appliquée lorsque des plus basses fréquences doivent être générées. La tension alternative est appliquée brièvement, par exemple pendant une durée de quelques µs à quelques ms selon la géométrie de la plaque, afin de provoquer un déplacement bref de la plaque autour de sa position apte à compenser partiellement ou complètement les contraintes résiduelles. Ce déplacement permet de générer une impulsion sonore basse fréquence.

La fréquence du premier mode de résonance d'un substrat encastré à sa périphérie peut s'exprimer approximativement par la formule suivante:

$$f_0 = 0.47 \frac{t}{a^2} \sqrt{\frac{E}{\rho}}$$

Avec t l'épaisseur du multicouche, a le rayon, E et p respectivement le module d'Young moyen et la densité moyenne du multicouche.

Sur la figure 6, on peut voir la variation de la fréquence de résonance Fq en Hz en fonction de l'épaisseur e en µm d'une plaque de 2 cm de rayon. On constate que l'on peut obtenir une fréquence de résonance et donc une contribution acoustique de l'ordre de 500 Hz, correspondant à une sensation de basse avec une plaque de 100 µm d'épaisseur. Cette épaisseur peut être facilement obtenue par un polissage mécano-chimique ou CMP (Chemical Mechanical Polishing en terminologie anglo-saxonne), par exemple cette épaisseur de 100 µm peut être obtenue à partir d'un substrat de 725 µm d'épaisseur qui est standard en microélectronique.

La tension alternative appliquée aux actionneurs de la plaque et les tensions alternatives appliquées aux actionneurs des membranes 4 sont appliquées de manière successive.

Sur la figure 3B, la vibration de la plaque 2 est symbolisée par la flèche F'.

Il sera compris que l'on pourrait envisager d'avoir une grande plaque comportant plusieurs plaques 2 portant chacune des membranes 4, la grande plaque pouvant être déformée pour compenser les contraintes résiduelles dans les plaques 2 formant des membranes, et les plaques 2 étant déformées pour compenser les contraintes résiduelles de membranes. Cette stratification peut être répétée plusieurs fois.

Sur la figure 5, on peut voir un autre exemple de réalisation dans lequel la plaque 2' est de forme rectangulaire, les membranes 4' sont de forme carrée et comporte deux actionneurs 12' en forme de bande disposés chacun le long d'un bord opposé de la plaque. Les membranes 4' pourraient avoir une autre forme, par exemple une forme de disque, une forme rectangulaire...

La plaque pourrait avoir une autre forme, par exemple toute forme polygonale.

De manière avantageuse, la forme et la taille des actionneurs sont déterminées afin de limiter la tension d'actionnement en fonction de la géométrie de la plaque.

La forme et la taille des actionneurs sont déterminées par exemple par la méthode des éléments finis, par exemple au moyen des logiciels CoventorWare®, COMSOL®, ANSYS®.

Le dispositif selon l'invention est particulière avantageux dans la réalisation de haut-parleurs digitaux puisqu'il permet de générer des basses fréquences et avantageusement deux niveaux de basses fréquences en utilisant la plaque comme membrane. Les haut-parleurs offrent alors une meilleure qualité de son.

Le dispositif selon la présente invention peut être appliqué dans tous les domaines techniques dans lesquels des membranes aptes à vibrer peuvent être mises en oeuvre. Par exemple il peut être utilisé dans une micropompe pour déplacer du liquide, les membranes déplaçant un certain volume et la plaque déplaçant avantageusement un autre volume. La compensation des contraintes internes permet d'avoir un comportement des membranes connu et maîtrisé. Le dispositif selon l'invention peut également être utilisé dans des dispositifs d'émission ultrasonore.

Un exemple de procédé de réalisation d'un dispositif selon l'invention va maintenant être décrit. Il s'agit avantageusement d'un procédé mettant en oeuvre des techniques de la microélectronique. Cet exemple de procédé illustre la réalisation d'un dispositif à deux actionneurs par membrane mettant en oeuvre un matériau ferroélectrique. Cet exemple de procédé s'applique également à la réalisation d'un actionneur par membrane mettant en oeuvre un matériau piézoélectrique tel que l'AlN.

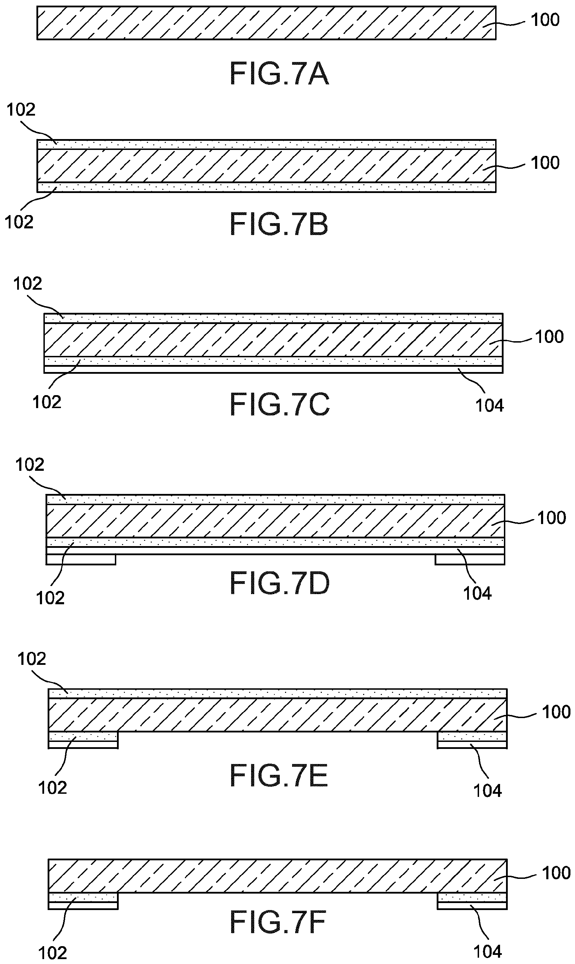

Les étapes représentées schématiquement sur les figures 7A à 7R représentent un détail du dispositif au niveau d'une membrane 4. Mais il sera compris que toutes les membranes sont réalisées simultanément dans un substrat formant la plaque Avantageusement, les actionneurs de la plaque sont réalisés en même temps que les actionneurs des membranes.

Par exemple, on utilise un substrat en silicium 100 représenté en partie sur la figure 7A, ayant par exemple une épaisseur de 725 $\mu$m et un diamètre de 200mm de diamètre. De préférence on part d'un substrat standard sur lequel on va réalise plusieurs dispositifs par exemple de diamètre 4cm de diamètre ou 6cm. A la fin du procédé de réalisation, le substrat est clivé afin de séparer les dispositifs.

Lors d'une première étape, on effectue une oxydation thermique du substrat de sorte à former une couche d'oxyde 102 sur toutes les surfaces du substrat d'une épaisseur de 2 $\mu$m par exemple. L'élément ainsi obtenu est représenté sur la figure 7B.

Ensuite, on réalise un masque dur d'oxyde 104 sur la face arrière du substrat. Ce masque a par exemple une épaisseur de 7 $\mu$m. Le masque est réalisé en retournant le substrat; en fonction de la composition de dépôt choisie; il est possible de ne déposer le masque que sur cette face. Il peut s'agir par exemple d'un dépôt de type PVD (Physical Vapor Deposition en terminologie anglo-saxonne). L'élément ainsi obtenu est représenté sur la figure 7C.

On effectue ensuite une lithographie sur le masque dur. L'élément ainsi obtenu est représenté sur la figure 7D.

Lors d'une étape suivante, on grave, par exemple par gravure ionique réactive (RIE : Reactive-Ion Etching en terminologie anglo-saxonne), le masque dur et la couche d'oxyde 102 en face arrière de sorte à atteindre la face arrière du substrat 100. L'élément ainsi obtenu est représenté sur la figure 7E.

Lors d'une étape suivante, on retire la couche d'oxyde sur la face avant, par exemple par désoxydation ou gravure chimique. L'élément ainsi obtenu est représenté sur la figure 7F.

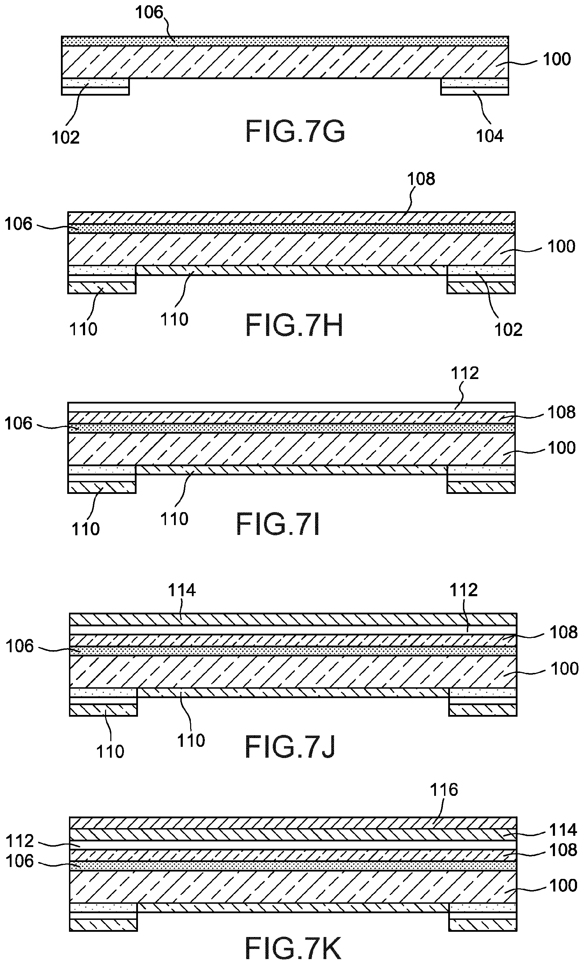

Lors d'une étape suivante, on forme une couche d'oxyde 106 en face avant. Avantageusement, un recuit de densification a lieu par exemple à une température de l'ordre de 800°C. L'élément ainsi obtenu est représenté sur la figure 7G.

Lors d'une étape suivante, on forme une couche 108 en face avant destinée à former la membrane 2, et une couche 110 en face arrière. De préférence, ces couches sont par exemple en polysilicium, en SiC ou en SiO$_2$. L'épaisseur des couches 108, 110 est par exemple comprise entre quelques centaines de nm à plusieurs $\mu$m, voire plusieurs dizaines de $\mu$m.

Les couches 108, 110 sont par exemple réalisées par dépôt chimique en phase vapeur (ou CVD pour Chemical Vapor Deposition en terminologie anglo-saxonne) ou par croissance épitaxiale. De préférence, les contraintes des couches 108, 110 sont maîtrisées.

Les couches 108, 110 peuvent être formées en plusieurs fois. Par exemple, pour une épaisseur de 4 $\mu$m, deux couches de 1,5 $\mu$m d'épaisseur et 1 couche de 1 $\mu$m d'épaisseur sont réalisées successivement.

Avantageusement une étape de recuit a ensuite lieu. L'élément ainsi obtenu est représenté sur la figure 7H.

Lors d'une étape suivante, une couche 112 est formée sur la couche 108, par exemple en SiO$_2$ ou en SiN, ayant par exemple une épaisseur comprise entre quelques centaines de nm et plusieurs $\mu$m. La couche 112 est formée par exemple par oxydation thermique ou par dépôt CVD. Avantageusement, un recuit de densification a lieu par exemple à une température de l'ordre de 800°C.

L'élément ainsi obtenu est représenté sur la figure 7I.

Lors d'une étape suivante, on réalise les premier et deuxième actionneurs.

Pour cela on réalise tout d'abord une couche 114 destinée à former les électrodes inférieures des actionneurs, par exemple en Pt ou en Mo. La couche 114 est réalisée par exemple par dépôt sur la couche 112. La couche 114 a par exemple une épaisseur comprise entre quelques dizaines de nm à quelques centaines de nm. L'élément ainsi obtenu est représenté sur la figure 7J.

Une couche de matériau ferroélectrique 116 est ensuite formée sur la couche 114, par exemple en PZT, ZnO, LNO dont l'épaisseur est par exemple comprise entre quelques centaines de nm à quelques $\mu$m. en variant la couche 116 pourrait être un matériau piézoélectrique, notamment lorsqu'un seul actionneur est réalisé.

On réalise ensuite l'électrode supérieure par formation d'une couche 118 sur le matériau piézoélectrique 116, par exemple en Ru ou en Au par exemple d'épaisseur comprise entre quelques dizaines de nm à quelques centaines de nm. L'élément ainsi obtenu est représenté sur la figure 7K.

Ont lieu ensuite des étapes de gravure.

Tout d'abord, la couche 118 est gravée de sorte à délimiter l'actionneur annulaire 8 et l'actionneur en forme de disque 10.

Ensuite, la couche 116 en matériau piézoélectrique est gravée.

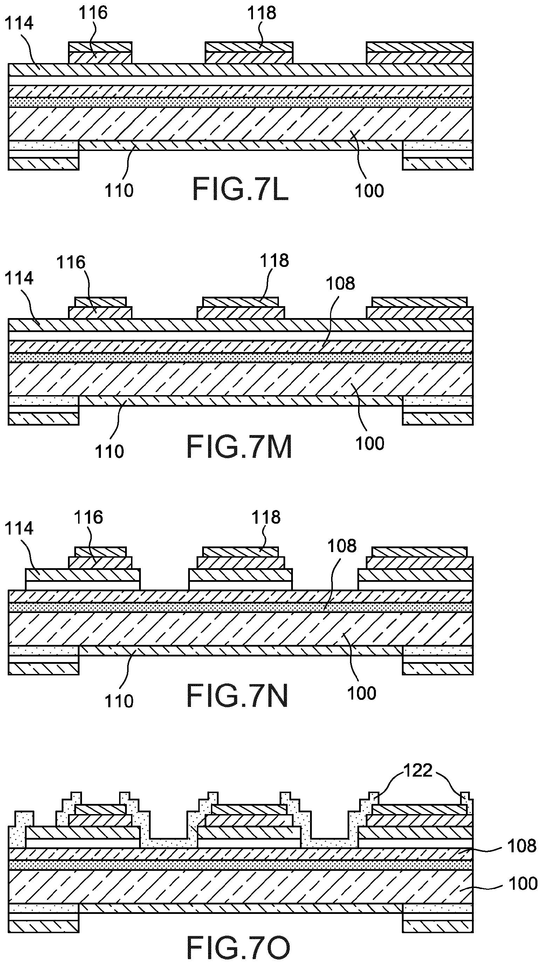

L'élément ainsi obtenu est représenté sur la figure 7L.

Ensuite, on grave à nouveau les portions de couche 118 restantes de sorte à ce qu'elles soient en retrait par rapport aux portions de couche 116.

La couche 114 est ensuite gravée, ainsi que la couche d'oxyde 112. L'élément ainsi obtenu est représenté sur la figure 7M.

De préférence, on réalise un profil en escalier. Celui-ci est obtenu car toutes les couches sont déposées puis gravées, à partir de la couche supérieure, en utilisant des masques de photolithographie différents, le deuxième masque étant plus large que le premier, etc. Cela permet de laisser des marges de sécurité pour éviter le recouvrement de couches, qui pourrait apparaître du fait de l'incertitude de positionnement des masques. On évite ainsi tout court circuit électrique entre les électrodes. L'élément ainsi obtenu est représenté sur la figure 7N.

Lors des étapes suivantes, on réalise des plots de reprise de contact 120. Préalablement on forme une couche 122 de matériau diélectrique, par exemple en $SiO_2$ sur les bords des empilements formés des électrodes inférieure, supérieure et du matériau piézoélectrique, cette couche étant gravée de sorte à dégager partiellement les électrodes inférieure et supérieure. L'élément ainsi obtenu est représenté sur la figure 7O.

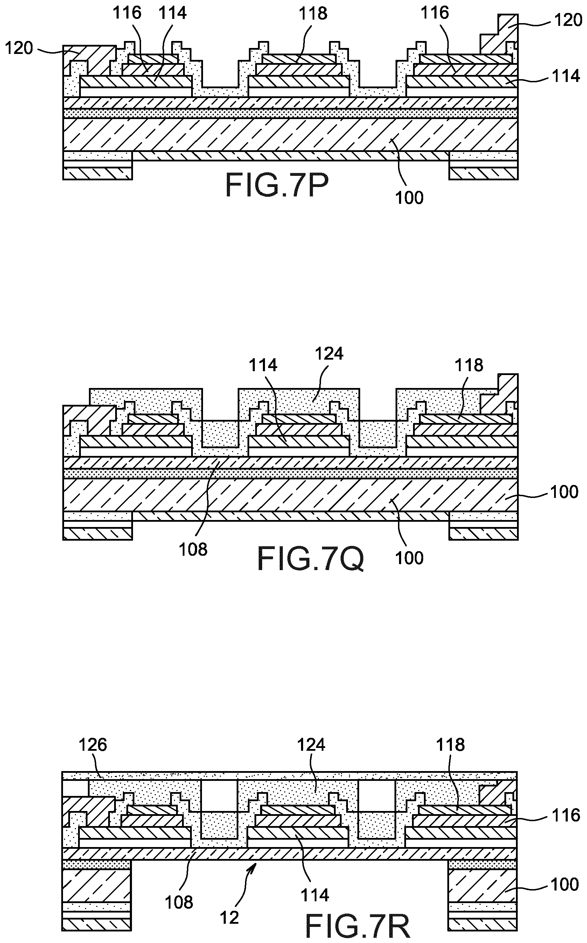

Ensuite, une couche par exemple en AlSi ou en TiAu est formée et est gravée, formant ainsi des plots de contact au niveau des zones où les électrodes ont été dégagées. L'élément ainsi obtenu est représenté sur la figure 7P.

Avantageusement, lors d'une étape suivante on forme une couche de protection 124 sur les actionneurs, par exemple une couche d'oxyde, afin de protéger les actionneurs du contact avec les éléments d'arrêt. L'épaisseur de cette couche peut être comprise entre quelques centaines de nm à quelques $\mu$m, par exemple 500nm.

Lors d'une étape suivante la couche 124 est gravée, pour accéder aux reprises de contact.

L'élément ainsi obtenu est représenté sur la figure 7Q.

De préférence, lors d'une étape suivante, on protège les actionneurs, par exemple par le dépôt d'un film sec 126. Ensuite, on grave la face arrière afin de libérer la membrane 2.

On libère la membrane par gravure profonde du substrat par la face arrière jusqu'à atteindre la membrane. Toutes les membranes sont en fait libérées simultanément.

L'élément ainsi obtenu est représenté sur la figure 7R.

Afin d'avoir un dispositif fonctionnel, nous pouvons découper le substrat afin d'individualiser les plaques. L'élément obtenu est ensuite associé à d'autres éléments notamment à une électronique de pilotage qui est connectées individuellement à chacune des électrodes. En outre la plaque munie des membranes peut elle-même être montée sur un support pour être apte à être déformée et avantageusement être apte à vibrer.

**Revendications**

1. Dispositif à membranes actionnables comportant une plaque (2, 2'), des membranes (4) suspendues à ladite plaque (2, 2'), lesdites membranes (4) étant le siège de contraintes mécaniques résiduelles, au moins un premier actionneur (12, 12') apte à déformer la plaque (4) hors de son plan, des deuxièmes actionneurs (6), chaque deuxième actionneur (6) étant apte à déformer une desdites membranes (4) hors de son plan, et une électronique de pilotage (EP) apte à générer des deuxièmes signaux de commande aux deuxièmes actionneurs (6) afin de mettre les membranes (4) en vibration et apte à générer des premiers signaux de commande continus au premier actionneur (12, 12') de sorte qu'il provoque une déformation de la plaque (2, 2') afin qu'elle se trouve dans un état déformé, qui est tel que des contraintes mécaniques induites, s'appliquent aux membranes (4) et au moins réduisent les contraintes résiduelles des membranes (4).

2. Dispositif à membranes actionnables selon la revendication 1, dans lequel les contraintes mécaniques induites appliquées aux membranes (4) annulent les contraintes résiduelles des membranes (4).

3. Dispositif à membranes actionnables selon la revendication 1 ou 2, dans lequel l'électronique de pilotage (EP) est apte en outre à générer des signaux de commande additionnels au premier actionneur (12, 12') de sorte qu'il provoque une mise en vibration de la plaque (2, 2'), indépendamment de sa mise dans son état déformé.

4. Dispositif à membranes actionnables selon l'une des revendications 1 à 3, dans lequel le premier actionneur (12, 12') et/ou les deuxièmes actionneurs (6) sont des actionneurs piézoélectriques et/ou ferroélectriques.

5. Dispositif à membranes actionnables selon l'une des revendications 1 à 4, dans lequel la surface totale du au moins un premier actionneur (12, 12') est comprise entre 5% et 40% de la surface de la plaque et/ou dans lequel la surface totale des deuxièmes actionneurs est comprise entre 5% et 40% de la surface totale des membranes.

6. Dispositif à membranes actionnables selon l'une des revendications 1 à 4, dans lequel la surface totale du au moins un premier actionneur (12, 12') est égale à 25% de la surface de la plaque (2, 2') et/ou dans lequel la surface totale des deuxièmes actionneurs est égale à 25% de la surface totale des membranes.

7. Dispositif à membranes actionnables selon l'une des revendications 1 à 6, comportant un ou plusieurs premiers actionneurs (12, 12') répartis le long d'au moins un bord de la plaque (2, 2').

8. Dispositif à membranes actionnables selon la revendication 7, dans lequel la plaque (2) a la forme d'un disque et le ou les premiers actionneurs (12) ont la forme d'arc de cercle centré sur le centre du disque , ou la plaque (2') a la forme d'un rectangle et dans lequel le dispositif comporte plusieurs premiers actionneurs (12') s'étendant parallèlement à au moins deux bords opposés de la plaque ou la plaque (2) a la forme d'un disque et le premier actionneur a la forme d'un anneau centré sur le centre du disque.

9. Dispositif à membranes actionnables selon l'une des revendications 1 à 8, dans lequel les membranes sont situées sur une face de la plaque.

10. Système comportant au moins un dispositif à membranes actionnables selon l'une des revendications 1 à 9, formant un haut-parleur digital ou un dispositif d'émission ultrasonore.

11. Micropompe hydraulique comportant au moins un dispositif à membranes actionnables selon l'une des revendications 1 à 9.

12. Procédé de fabrication d'un dispositif à membranes actionnables selon l'une des revendications 1 à 9, comportant les étapes :

a) choix d'un nombre de membranes et des dimensions respectives de celles-ci,
b) détermination des contraintes résiduelles aux membranes,
c) détermination des dimensions de la plaque,
d) détermination de la déformation requise de la plaque pour réduire et avantageusement annuler les contraintes résiduelles dans les membranes,
e) fabrication d'un dispositif à membranes actionnables comportant une plaque présentant les dimensions déterminées, au moins un premier actionneur apte à provoquer la déformation déterminée de la plaque, des membranes ayant les dimensions choisies et des deuxièmes actionneurs aptes à mettre en vibration les membranes, le premier actionneur et les deuxièmes actionneurs étant avantageusement réalisés simultanément.

13. Procédé selon la revendication 12, dans lequel les étapes b), c) et d) sont réalisées par une méthode d'éléments finis.

14. Procédé de commande d'un système formant haut-parleur digital selon la revendication 10, comportant les étapes :

- génération des premiers signaux continus de commande au premier actionneur provoquant la déformation de la plaque,
- génération des deuxièmes signaux de commande à tout ou partie des membranes en fonction du son à produire.

15. Procédé de commande d'un haut-parleur digital selon la revendication 14, comportant l'étape supplémentaire de génération du signal de commande additionnel de type alternatif au premier actionneur mettant en vibration la plaque.

**Patentansprüche**

1. Vorrichtung mit betätigbaren Membranen, umfassend eine Platte (2, 2'), Membranen (4), die an der Platte (2, 2') aufgehängt sind, wobei die Membranen (4) der Sitz von mechanischen Restspannungen sind, wenigstens ein erstes Betätigungselement (12, 12'), das dazu ausgelegt ist, die Platte (4) aus ihrer Ebene heraus zu verformen, zweite Betätigungselemente (6), wobei jedes zweite Betätigungselement (6) dazu ausgelegt ist, eine der Membranen (4) aus ihrer Ebene heraus zu verformen, sowie eine Steuerungselektronik (EP), die dazu ausgelegt ist, zweite Steuersignale bei den zweiten Betätigungselementen (6) zu erzeugen, um die Membranen (4) in Schwingung zu versetzen, und dazu ausgelegt ist, erste kontinuierliche Steuersignale bei dem ersten Betätigungselement (12, 12') derart zu erzeugen, dass es eine Verformung der Platte (2, 2') hervorruft, damit sie sich in einem verformten Zustand befindet, der derart ist, dass induzierte mechanische Spannungen an die Membranen (4) angelegt werden und die Restspannungen der Membranen (4) mindestens reduzieren.

2. Vorrichtung mit betätigbaren Membranen nach Anspruch 1, bei der die an die Membranen (4) angelegten induzierten mechanischen Spannungen die Restspannungen der Membranen (4) auslöschen.

3. Vorrichtung mit betätigbaren Membranen nach Anspruch 1 oder 2, bei der die Steuerungselektronik (EP) ferner dazu ausgelegt ist, zusätzliche Steuersignale bei dem ersten Betätigungselement (12, 12') derart zu erzeugen, dass es ein in Schwingung Versetzen der Platte (2, 2') unabhängig davon hervorruft, dass sie in ihren verformten Zustand versetzt wird.

4. Vorrichtung mit betätigbaren Membranen nach einem der Ansprüche 1 bis 3, bei der das erste Betätigungselement (12, 12') und/oder die zweiten Betätigungselemente (6) piezoelektrische und/oder ferroelektrische Betätigungselemente sind.

5. Vorrichtung mit betätigbaren Membranen nach einem der Ansprüche 1 bis 4, bei der die Gesamtoberfläche des wenigstens einen ersten Betätigungselements (12, 12') zwischen 5% und 40% der Oberfläche der Platte enthalten ist, und/oder bei der die Gesamtoberfläche der zweiten Betätigungselemente zwischen 5% und 40% der Gesamtoberfläche der Membranen enthalten ist.

6. Vorrichtung mit betätigbaren Membranen nach einem der Ansprüche 1 bis 4, bei der die Gesamtoberfläche des wenigstens einen ersten Betätigungselements (12, 12') gleich 25% der Oberfläche der Platte (2, 2') ist, und/oder bei der die Gesamtoberfläche der zweiten Betätigungselemente gleich 25% der Gesamtoberfläche der Membranen ist.

7. Vorrichtung mit betätigbaren Membranen nach einem der Ansprüche 1 bis 6, umfassend ein oder mehrere erste Betätigungselemente (12, 12'), die entlang wenigstens eines Rands der Platte (2, 2') verteilt sind.

8. Vorrichtung mit betätigbaren Membranen nach Anspruch 7, bei der die Platte (2) die Form einer Scheibe hat, und das oder die ersten Betätigungselemente (12) eine Kreisbogenform haben, die auf dem Zentrum der Scheibe zentriert ist, oder bei der die Platte (2') die Form eines Rechtecks hat, und bei der die Vorrichtung mehrere erste Betätigungselemente (12') umfasst, die sich parallel zu wenigstens zwei entgegengesetzten Rändern der Platte erstrecken, oder bei der die Platte (2) die Form einer Scheibe hat, und das erste Betätigungselement die Form eines Rings hat, der auf dem Zentrum der Scheibe zentriert ist.

9. Vorrichtung mit betätigbaren Membranen nach einem der Ansprüche 1 bis 8, bei der die Membranen auf einer Fläche der Platte angeordnet sind.

10. System, umfassend wenigstens eine Vorrichtung mit betätigbaren Membranen nach einem der Ansprüche 1 bis 9, das einen digitalen Lautsprecher oder eine Ultraschallemissionsvorrichtung bildet.

11. Hydraulische Mikropumpe, umfassend wenigstens eine Vorrichtung mit betätigbaren Membranen nach einem der Ansprüche 1 bis 9.

12. Verfahren zur Herstellung einer Vorrichtung mit betätigbaren Membranen nach einem der Ansprüche 1 bis 9, umfassend die Schritte:

a) Auswählen einer Zahl von Membranen und von jeweiligen Abmessungen derselben,
b) Bestimmen der Restspannungen bei den Membranen,
c) Bestimmen der Abmessungen der Platte,
d) Bestimmen der erforderlichen Verformung der Platte, um die Restspannungen in den Membranen zu reduzieren und vorzugsweise auszulöschen,
e) Herstellen einer Vorrichtung mit betätigbaren Membranen, umfassend eine Platte, die die bestimmten Abmessungen aufweist, wenigstens ein erstes Betätigungselement, das dazu ausgelegt ist, die bestimmte Verformung der Platte hervorzurufen, Membranen, die die ausgewählten Abmessungen haben, sowie zweite Betätigungselemente, die dazu ausgelegt sind, die Membrane in Schwingung zu versetzen, wobei das erste Betätigungselement und die zweiten Betätigungselemente vorzugsweise gleichzeitig realisiert werden.

13. Verfahren nach Anspruch 12, bei dem die Schritte b), c) und d) durch ein Verfahren der finiten Elemente realisiert werden.

14. Verfahren zur Steuerung eines Systems, das einen digitalen Lautsprecher nach Anspruch 10 bildet, umfassend die Schritte:

- Erzeugen der ersten kontinuierlichen Steuersignale bei dem ersten Betätigungselement, das die Verformung der Platte hervorruft,
- Erzeugen der zweiten Steuersignale bei allen oder einem Teil der Membranen als Funktion des zu erzeugenden Tons.

15. Verfahren zur Steuerung eines digitalen Lautsprechers nach Anspruch 14, umfassend den zusätzlichen Schritt des Erzeugens des zusätzlichen Steuersignals vom alternierenden Typ beim ersten Betätigungselement, das die Platte in Schwingung versetzt.

**Claims**

1. An operable membranes device comprising a plate (2, 2'), membranes (4) suspended from said plate (2, 2'), said membranes (4) being the seat of residual mechanical constraints, at least a first actuator (12, 12') able to deform the plate (4) outside its plane, second actuators (6), each second actuator (6) being able to deform one of said membranes (4) outside its plane, and control electronics (EP) able to generate second control signals at the second actuators (6) in order to vibrate the membranes and able to generate continuous first control signals at the first actuator (12, 12') such that it causes a deformation of the plate (2, 2') so that it is found in the deformed state, which is such that induced mechanical constraints apply to the membranes (4) and at least reduce the residual constraints of the membranes (4).

2. The operable membrane device according to claim 1, wherein the induced mechanical constraints applied to the membranes (4) cancel out the residual constraints of the membranes (4).

3. The operable membrane device according to claim 1 or 2, wherein the control electronics (EP) are further able to generate control signals in addition to the first actuator (12, 12') such that it causes the plate (2, 2') to be vibrated, independently of its deformation.

4. The operable membrane device according to one of claims 1 to 3, wherein the first actuator (12, 12') and/or the second actuators (6) are piezoelectric and/or ferroelectric actuators.

5. The operable membrane device according to one of claims 1 to 4, wherein the total surface of at least one first actuator (12, 12') comprised between 5% and 40% of the surface of the plate and/or wherein the total surface of the second actuators is comprised between 5% and 40% of the total surface of the membranes.

6. The operable membrane device according to one of claims 1 to 4, wherein the total surface of at least one first actuator (12,12') is equal to 25% of the surface of the plate and/or wherein the total surface of the second actuators is equal to 25% of the total surface of the membranes.

7. The operable membrane device according to one of claims 1 to 6, comprising one or several first actuators (12, 12') distributed along at least one edge of the plate (2, 2').

8. The operable membrane device according to claim 7, wherein the plate (2) is in the form of a disc and the first actuator(s) (12) are in the form of an arc of circle centered on the center of the disc, or the plate (2') is in the form of a rectangle and where the device comprises several first actuators (12') extending parallel to at least two opposite edges of the plate (2), or the plate (2) is in the form of a disc and the first actuator is in the form of a ring centered on the center of the disc.

9. The operable membrane device according to one of claims 1 to 8, wherein the membranes are situated on one face of the plate.

10. System comprising at least one operable membrane device according to one of claims 1 to 9, forming a digital speaker or an ultrasound emission device.

11. A hydraulic micro-pump comprising at least one operable membrane device according to one of claims 1 to 9.

12. A method for manufacturing an operable membranes device according to one of claims 1 to 9, comprising the following steps:

    a) choosing a number of membranes and the respective dimensions thereof,
    b) determining the residual constraints in the membranes,
    c) determining the dimensions of the plate,
    d) determining the required deformation of the plate to reduce and advantageously cancel out the residual constraints in the membranes,
    e) manufacturing an operable membrane device comprising a plate having the determined dimensions, at least one first actuator being able to cause the determined deformation of the plate, membranes having the chosen dimensions and second actuators able to vibrate the membranes.

13. The method according to claim 12, wherein steps b), c) and d) are carried out by a finite elements method.

14. A method for controlling a digital speaker according to claim 10, comprising the following steps:

    - generating a first continuous control signal at the first actuator causing the deformation of the plate,
    - generating second control signals at all or part of the membranes as a function of the sound to be produced.

15. The method for controlling a digital speaker according to claim 14, comprising the additional step of generating an additional control signal of the alternating type at the first actuator vibrating the plate.

FIG.1

FIG.2

FIG.3A

FIG.3B

FIG.4

FIG.5

FIG.6

100

FIG.7A

102

100

102

FIG.7B

102

100

102                                        104

FIG.7C

102

100

102                                        104

FIG.7D

102

100

102                                        104

FIG.7E

100

102                                        104

FIG.7F

FIG.7G

FIG.7H

FIG.7I

FIG.7J

FIG.7K

FIG.7L

FIG.7M

FIG.7N

FIG.7O

FIG.7P

FIG.7Q

FIG.7R

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2747452 A

- JP 2013102024 B

**Littérature non-brevet citée dans la description**

- **DEJAEGER et al.** Development and characterization of a piezoelectrically actuated MEMS digital loudspeaker. *Proc. Eurosensors XXVI,* 09 Septembre 2012

- **R. DEJAEGER.** Modelisations multiphysiques, réalisation et expérimentation d'un haut-parleur digital matriciel piezoélectriques MEMS. Université de Lyon, 01 Janvier 2014, 25-27, 49-59